# EUROPEAN PATENT SPECIFICATION

(11) **EP 1 117 734 B1**
(45) Date of publication and mention of the grant of the patent: **14.09.2005**
(21) Application number: 99937455.6
(22) Date of filing: 22.07.1999
(51) Int. Cl.: C08K 5/5399, C08L 77/00, C08K 5/092

(54) **FLAME RESISTANT POLYPHENYLENE ETHER-POLYAMIDE RESIN BLENDS**
FLAMMHEMMENDE POLYPHENYLENETHER-POLYAMID HARZMISCHUNGEN
MELANGES DE RESINES DE POLY(PHENYLENETHER)-POLYAMIDE IGNIFUGES

(30) Priority: 31.08.1998 US 144687; 22.01.1999 US 235985
(43) Date of publication of application: 25.07.2001
(73) Proprietor: GENERAL ELECTRIC COMPANY, Schenectady, NY 12345 (US)
(72) Inventor: LANDA, Adrie, NL-4615 DB Bergen op Zoom (NL)
(74) Representative: Szary, Anne Catherine
(86) International application number: PCT/US1999/016815
(87) International publication number: WO 2000/012610

(56) References cited:
- EP-A- 0 171 730
- EP-A- 0 683 209
- WO-A-93/22373
- DE-A- 1 544 869
- TALLEY, JOHN J.: "Preparation of sterically hindered phosphoramidates" JOURNAL OF CHEMICAL AND ENGINEERING DATA., vol. 33, no. 2, 1988, pages 221-222, XP002121336 AMERICAN CHEMICAL SOCIETY., US ISSN: 0021-9568 cited in the application

## Description

The invention relates to flame retardant compositions of compatibilized polyphenylene ether-polyamide resin blends containing at least one phosphoramide compound.

The invention also relates to the methods to prepare flame retardant compositions of compatibilized polyphenylene ether-polyamide resin blends and articles formed out of the compositions.

Poly(phenylene ether) resins (referred to hereafter as "PPE") are commercially attractive materials because of their unique combination of physical, chemical, and electrical properties. Furthermore, the combination of these resins with polyamide resins into compatibilized blends results in additional overall properties such as chemical resistance, high strength, and high flow. Examples of such compatibilized blends can be found in U.S. Patents 4,315,086 (Ueno, et al); 4,659,760 (van der Meer); and 4,732,938 (Grant, et al). The properties of these blends can be further enhanced by the addition of various additives such as impact modifiers, light stabilizers, processing stabilizers, heat stabilizers, antioxidants and fillers.

The physical properties of PPE/polyamide blends make them attractive for a variety of end-use articles in the automotive market, especially for under hood and various exterior components. Additional applications in other markets have been somewhat limited by the lack of an effective flame retardant system for these blends. Some of the desirable applications, for example, electrical connectors require a flame rating in the Underwriters Laboratory UL-94 protocol of at least, V-0, V-1, or V-2. The same resins must also have outstanding ductility, flow, and surface appearance. Conventional phosphate ester flame retardant additives when utilized in PPE/polyamide blends have an inadequate balance of properties to widely penetrate many potential markets.

It is therefore apparent that a need continues to exist for flame retardant PPE/polyamide compositions that retain the other attractive physical properties.

The present invention provides resin compositions comprising a compatibilized polyphenylene ether-polyamide resin composition and at least is one phosphoramide compound. The present invention also provides articles made from the resin compositions in addition to methods to make flame retardant compatibilized polyphenylene ether-polyamide resin compositions.

In the practice of the invention, the resin composition comprises a compatibilized blend of a polyphenylene ether resin and a polyamide resin. Compatibilized blends of a polyphenylene ether resin and a polyamide resin are generally known in the art. These blends are typically made through reactive compounding techniques involving addition of a compatibilizing agent to compositions containing polyphenylene ether resin and polyamide resin. The compatibilizing agent is thought to result in reaction products between the polyphenylene ether resin and a polyamide resin and that these reaction products improve the compatibility between the polyphenylene ether resin and polyamide resin. The improved compatibility results in enhanced physical properties such as, for example, increased ductility. Illustrative compatibilizing agents for blends of polyphenylene ether resin and polyamide resin include citric acid, maleic anhydride, fumaric acid, malic acid as well as various derivatives of the foregoing.

The ratio of polyphenylene ether resin to polyamide resin can vary widely but is preferably adjusted so that the polyamide resin remains the continuous phase. Preferably the polyamide is at least about 40% by weight of the total resin composition. Increasing the level of the polyamide results in enhanced ductility and flow and is often preferred. The resin compositions may contain more than one type of polyamide resin such as a blend of nylon 6 and nylon 6,6. Moreover, the amine to acid endgroup ratio of the polyamide resin may also be varied as well as the relative viscosity of the polyamide contained within the resin composition.

The polyphenylene ether resins useful in the present invention include all known polyphenylene ether resins. Preferable resins include poly(2,6-dimethylphenylene ether) as well as the copolymer resins of 2,6-dimethylphenol and 2,3,6-trimethylphenol. These and other variations of the polyamide and the polyphenylene ether resins do not detract from the present invention.

The compatibilized blend of polyphenylene ether resin and polyamide resin may additionally contain various property modifiers such as elastomers for ductility enhancement. Useful elastomers for this purpose are known in the art and include, for example, styrenic block copolymers and various acid functionalized ethylene-propylene copolymers (e.g., EP-graft-maleic anhydride). Especially preferred are the so called elastomeric block copolymers, for example, A-B-A triblock copolymers and A-B diblock copolymers. The A-B and A-B-A type block copolymer rubber additives which may be used are thermoplastic rubbers comprised of one or two alkenyl aromatic blocks which are typically styrene blocks and a rubber block, e.g., a butadiene block which may be partially or totally hydrogenated. Mixtures of these triblock copolymers and diblock copolymers are especially preferred in the present compositions.

Suitable A-B and A-B-A type block copolymers are disclosed in, for example, U.S. Patent Nos. 3,078,254, 3,402,159, 3,297,793, 3,265,765, and 3,594,452 and U.K Patent 1,264,741. Examples of typical species of A-B and A-B-A block copolymers include polystyrene-polybutadiene (SBR), polystyrene-poly(ethylene-propylene), polystyrene-polyisoprene, poly(α-methylstyrene)-polybutadiene, polystyrene-polybutadiene-polystyrene (SBR), polystyrene-poly(ethylene-butylene)-polystyrene, polystyrene-polyisoprene-polystyrene and poly(α-methylstyrene)-polybutadiene-poly(α-methylstyrene), as well as the selectively hydrogenated versions thereof. Mixtures of the aforementioned block copolymers are also useful. Such A-B and A-B-A block copolymers are available commercially from a number of sources, including Phillips Petroleum under the trademark SOLPRENE, Shell Chemical Co., under the trademark KRATON, Dexco under the tradename VECTOR, and Kuraray under the trademark SEPTON.Other property modifiers include nucleating agents, stabilizers, pigments, dyes, and mineral fillers and reinforcing agents.

Also useful elastomers include functionalized elastomeric polyolefins such as elastomeric polyolefins containing at least one moiety of the group consisting of anhydride, epoxy, oxazoline, and orthoester. The essential structural units of the elastomeric polyolefin are derived from ethylene and at least one C₃₋₈ 1-olefin, such as, propylene, 1-butene, 1-hexene, and 1-octene. The proportions of ethylene and at least one C₃₋₈ 1-olefin are not critical provided that they together constitute the major portion of the polymer.

In a preferred embodiment, the functionalized elastomeric polyolefin is a functionalized ethylene-propylene rubber or a functionalized ethylene-propylene-diene elastomer. The diene portion is at least one non-conjugated diene, such as ethylidene norbornene, 1,4-hexadiene, or dicyclopentadiene. These elastomeric polyolefins are known in the art as EPR and EPDM elastomers.

A useful amount of the optional elastomeric block copolymers is between about 1% and about 15% by weight, preferably between about 1% and about 10% by weight, wherein the weight percentages are based on the entire weight of the composition. Mixtures of the previous described impact modifiers are also useful.

Another constituent of the resin compositions of the invention is at least one phosphoramide preferably having a glass transition point of at least about 0°C, more preferably of at least about 10°C, and most preferably of at least about 20°C, of the formula I: 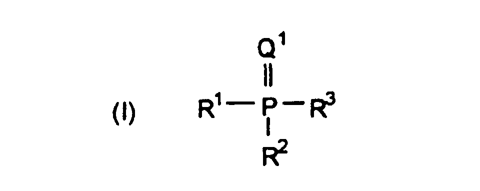 wherein R¹ is an amine residue, and R² and R³ are independently an alkyloxy residue, aryloxy residue, aryloxy residue containing at least one alkyl or one halogen substitution or mixture thereof, or amine residue; and Q¹ is oxygen or sulfur. Oxygen is particularly preferred as the Q¹ moiety. The compositions may contain essentially a single phosphoramide or a mixture of two or more different types of phosphoramides. Compositions containing essentially a single phosphoramide are preferred.

It was unexpectedly found that phosphoramide compounds as described herein have significantly less affect on the polyamide amine endgroup number and/or molecular weight of the polyamide resin as compared to organophosphate esters known in the art for enhancing flame retardancy properties. It is preferred that the phosphoramide have a glass transition point of at least about 0°C, preferably of at least about 10°C, and most preferably of at least about 20°C. When a phosphoramide having a glass transition point of at least about 0°C is used as a source of phosphorous in resin compositions, it was unexpectedly found that a higher heat deflection temperature of test specimens made from the resin composition could be obtained as compared to compositions containing an organophosphate ester known in the art.

Although the invention is not dependent upon mechanism, it is believed that selection of each of R¹, R², and R³ residues that result in restricted rotation of the bonds connected to the phosphorus provide an increased glass transition point in comparison to similar phosphoramides with residues having a lesser degree of restriction. Residues having bulky substituents such as, for example, aryloxy residues containing at least one halogen, or preferably at least one alkyl substitution, result in phosphoramides having a higher glass transition point than similar phosphoramides without the substitution on the aryloxy residue. Likewise, residues wherein at least two of the R¹, R², and R³ residues are interconnected, such as a neopentyl residue for the combination of the R² and R³ residues, can lead to desired phosphoramides having a glass transition point of at least about 0°C.

In a preferred embodiment, the phosphoramide comprises a phosphoramide having a glass transition temperature of at least about 0°C, preferably of at least about 10°C, and most preferably of at least about 20°C, of the formula VI: 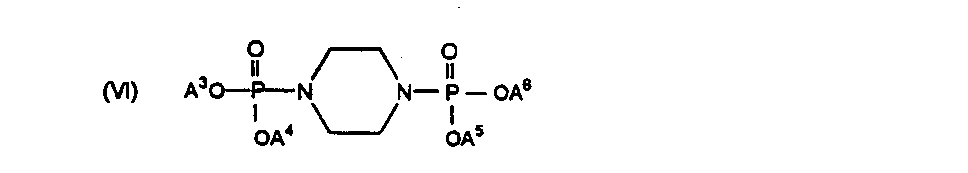 wherein each of A³⁻⁶ is an alkyl radical, aryl radical, or aryl radical containing at least one alkyl or halogen substitution or mixture thereof, or an amine residue.

In an especially preferred embodiment of the invention, each A³⁻⁶ moiety is a 2,6-dimethylphenyl moiety or a 2,4,6-trimethylphenyl moiety. These phosphoramides are piperazine-type phosphoramides. In the above formula wherein each A³⁻⁶ moiety is a 2,6-dimethylphenyl moiety, the glass transition temperature of the corresponding phosphoramide is about 62°C and the melting point is about 192°C. Conversely, in the above formula wherein each A³⁻⁶ moiety is phenyl, the glass transition temperature of the corresponding phosphoramide is about 0°C and the melting point is about 188°C. It was unexpected that the glass transition temperature would be so high (i.e. about 62°C) for the phosphoramide of formula wherein each of A³⁻⁶ is a 2,6-dimethylphenyl moiety as compared to the corresponding phosphoramide of formula wherein each of A³⁻⁶ is a phenyl moiety (i.e. about 0°C), especially since the melting points for the phosphoramides differ by only about 4°C. For comparison, the glass transition temperature of tetraphenyl resorcinol diphosphate is about -38°C. It is also possible to make phosphoramides with intermediate glass transition temperatures by using a mixture of various substituted and non-substituted aryl moieties within the phosphoramide.

In another preferred embodiment, the phosphoramide comprises a phosphoramide having a glass transition temperature of at least about 0°C, preferably of at least about 10°C, and most preferably of at least about 20°C, of the formula VII: 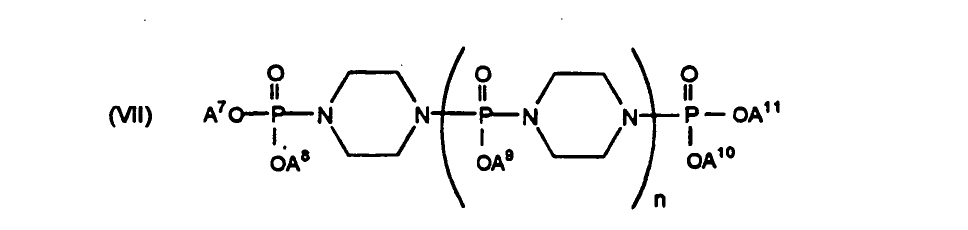 wherein each of A⁷⁻¹¹ is independently an alkyl radical, aryl radical, or aryl radical containing at least one alkyl or halogen substitution or mixture thereof, or an amine residue, and n is from 0 to about 5. In a more preferred embodiment, each A⁷⁻¹¹ moiety is independently phenyl, 2,6-dimethylphenyl, or 2,4,6-trimethylphenyl and n is from 0 to about 5.

In another embodiment of the invention the phosphoramide comprises a phosphoramide having a glass transition temperature of at least about 0°C, preferably of at least about 10°C, and most preferably of at least about 20°C, of the formula VIII : 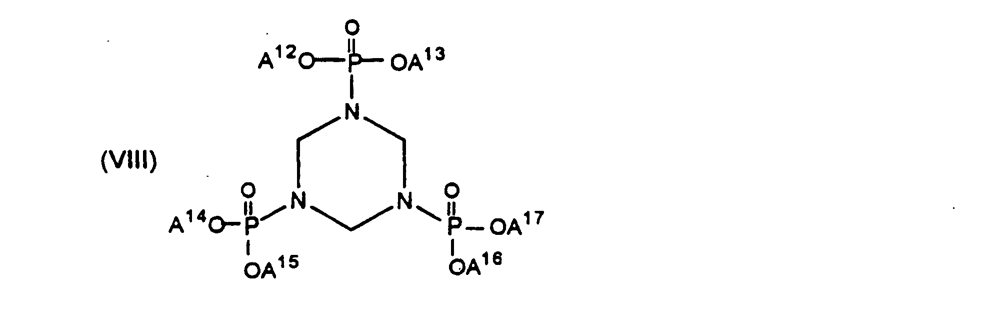 wherein each of A¹²⁻¹⁷ is independently an alkyloxy radical, aryloxy radical, or aryloxy radical containing at least one alkyl or halogen substitution or mixture thereof, or an amine residue.

In another embodiment of the invention the phosphoramide comprises a phosphoramide having a glass transition temperature of at least about 0°C, preferably of at least about 10°C, and most preferably of at least about 20°C, of the formula IX: 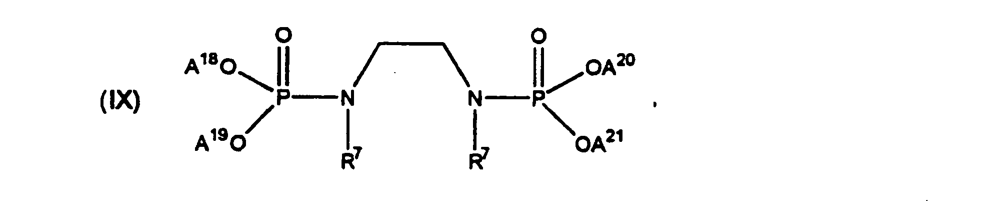 wherein each of A¹⁸⁻²⁰ an alkyl, aryl, or an aryl radical containing at least one alkyl or halogen substitution or mixture thereof, or an amine residue, and each R⁷ is an alkyl radical or both R⁷ radicals taken together are an alkylene radical.

In another embodiment of the invention, the phosphoramide comprises a phosphoramide having a glass transition point of at least about 0°C, preferably of at least about 10°C, and most preferably of at least about 20°C, of the formula I: 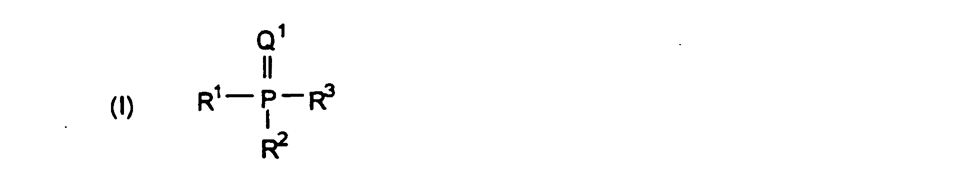 wherein R¹ is of the formula X: 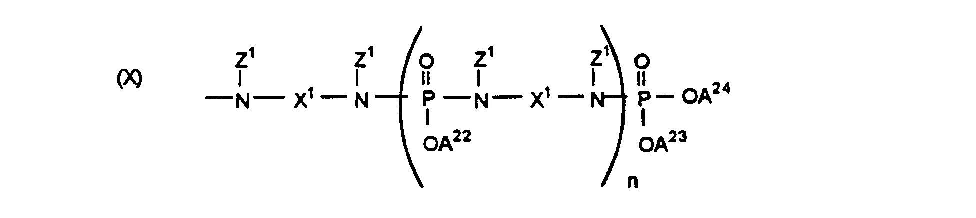 wherein each of A²²⁻²⁴ is an alkyl radical, aromatic radical, or aromatic radical containing at least one alkyl or halogen substitution or mixture thereof, or an amine residue; each Z¹ is an alkyl radical, aromatic radical, or aromatic radical containing at least one alkyl or halogen substitution or mixture thereof; each X¹ is an alkyl radical, aromatic radical, or aromatic radical containing at least one alkyl or halogen substitution or mixture thereof, and n is from 0 to about 5, and R² and R³ are independently an alkyloxy residue, aryloxy residue, aryloxy residue containing at least one alkyl or halogen substitution or mixture thereof, or an amine residue.

In another embodiment of the invention, the phosphoramide comprises a phosphoramide having a glass transition point of at least about 0°C, preferably of at least about 10°C, and most preferably of at least about 20°C, of the formula I: 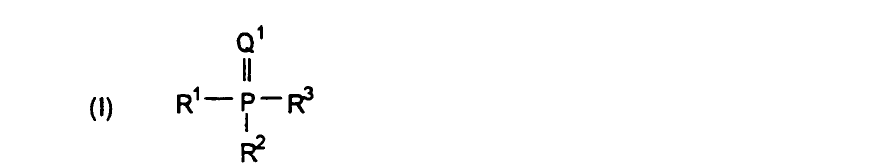 wherein R¹ is of the formula XI: 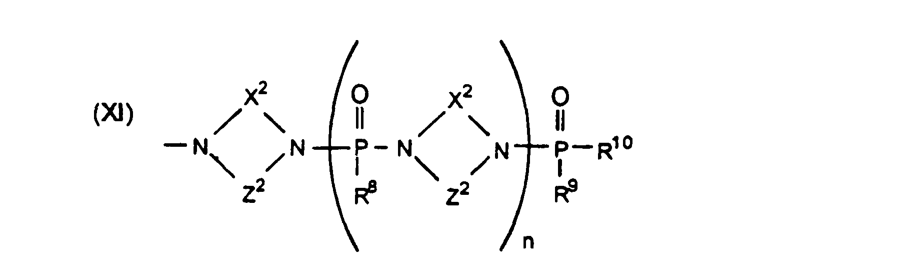 wherein each X² is alkyl, aryl, or alkaryl, each Z² is alkyl, each of R⁸, R⁹, and R¹⁰ is independently an alkyloxy residue, aryloxy residue, aryloxy residue containing at least one alkyl or halogen substitution or mixture thereof, or an amine residue, and n is from 0 to about 5, and R² and R³ are independently an alkyloxy residue, aryloxy residue, aryloxy residue containing at least one alkyl or halogen substitution or mixture thereof, or an amine residue. In an especially preferred embodiment, the phosphoramide is derived from piperazine (i.e. X² and Z² are each -CH₂-CH₂-).

In another preferred embodiment, the phosphoramide comprises a cyclic phosphoramide having a glass transition point of at least about 0°C, preferably of at least about 10°C, and most preferably of at least about 20°C of the formula XII : 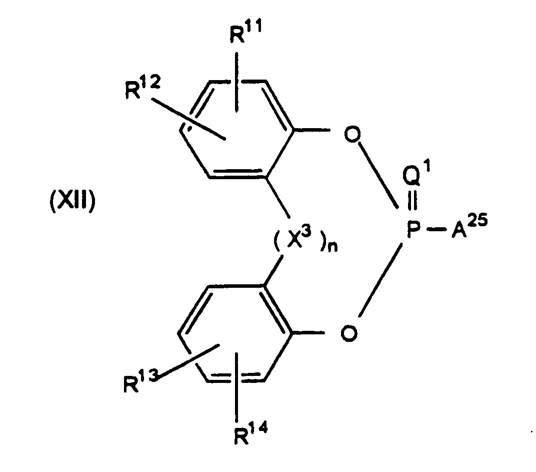 wherein each of R¹¹⁻¹⁴ is independently a hydrogen or an alkyl radical, X³ is an alkylidene radical, Q¹ is oxygen or sulfur, and A²⁵ is a group derived from a primary or secondary amine having the same or different radicals that can be aliphatic, alicyclic, aromatic, or alkaryl, or A²⁵ is a group derived from a heterocyclic amine, or A²⁵ is a hydrazine compound. Preferably Q¹ is oxygen. It should be noted that when n is 0, then the two aryl rings are linked together at that site (i.e. where X³ is absent) by a single bond in the positions ortho,ortho' to the phosphoryl bonds.

In another preferred embodiment, the phosphoramide comprises a cyclic phosphoramide having a glass transition point of at least about 0°C, preferably of at least about 10°C, and most preferably of at least about 20°C of the formula XIII: 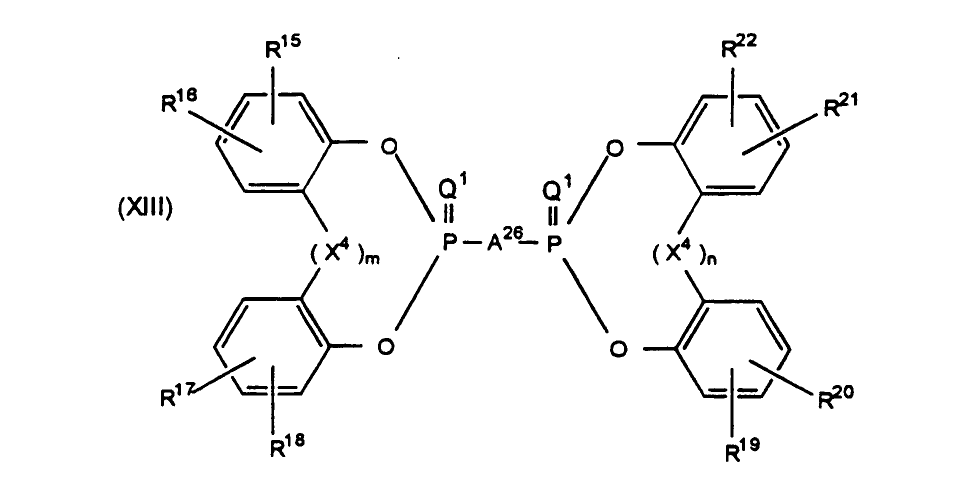 wherein Q¹ is oxygen or sulfur; each of R¹⁵⁻²² is independently a hydrogen or an alkyl radical; X⁴, when present, is an alkylidene radical; m and n are each independently 0 or 1; and A²⁶ is 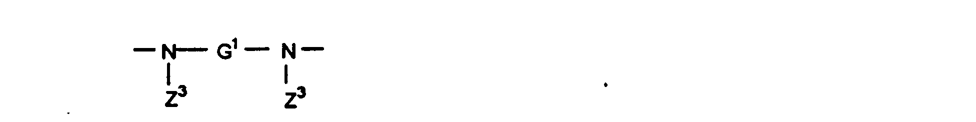 wherein G' is sulfur, an alkyl radical, aryl radical, or alkaryl radical and each Z³ is independently an alkyl radical or an aryl radical; or wherein A²⁶ is 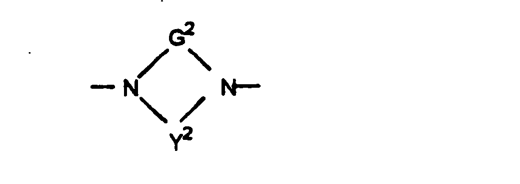 wherein G² is alkyl, aryl, or alkaryl, and Y² is alkyl. Preferred phosphoramides are those wherein Q is oxygen, A²⁶ is a residue of piperazine, and the phosphoramide has a center of symmetry at A²⁶. Highly preferred phosphoramides include those wherein Q¹ is oxygen, A²⁶ is a residue of piperazine, the phosphoramide has a center of symmetry at A²⁶, and at least one R substituent on each aryl ring is a methyl adjacent to the oxygen substituent, n and m are each 1, and X⁴ is CHR²³ wherein R²³ is a hydrogen or an alkyl residue of from about 1 to about 6 carbon atoms. It should be noted that when either or both of m or n is 0, then the two aryl rings are linked together at that site (i.e. where X⁴ is absent) by a single bond in the positions ortho,ortho' to the phosphoryl bonds.

It should be noted that in the descriptions herein, the words "radical" and "residue" used interchangeably, e.g. alkyl radical and alkyl residue are both intended to designate an alkyl moiety.

Phosphoramides of useful molecular structure are preferably prepared by the reaction of a corresponding amine such as, for example, piperazine or N,N'-dimethylethylenediamine with a diaryl chlorophosphate of the formula (aryl-O)₂POCl in the presence of a tertiary amine. This method of preparation is described in Talley, *J*. *Chem. Eng. Data,* 33, 221-222 (1988) and leads to specific phosphoramide compounds without repeating units. Alternatively, phosphoramides may be prepared by the reaction of the corresponding amine with P(O)Cl₃ in the presence of a tertiary amine, with the desired hydroxyl containing compound added simultaneously or subsequently to the addition of the amine. Addition of a diamine or triamine to P(O)Cl₃ with simultaneous or subsequent addition of the hydroxyl containing compound is believed to lead to repeating units of phosphoramide, often of 1 to about 5 phosphoramide linkages per compound. Similarly, addition of a diamine or triamine to a monosubstituted phosphoryl dichloride with simultaneous or subsequent addition of hydroxyl containing compound is also believed to lead to repeating units of phosphoramide.

The resinous compositions of this invention typically contain a flame retarding and/or processability enhancing amount of at least one phosphoramide. Flame retardancy is preferably measured according to the Underwriters' Laboratory UL-94 protocol. A flame retarding amount is a amount effective to render the composition at least a V-2 rating, preferably at least a V-1 rating, and most preferably a V-0 rating after testing in the UL-94 protocol at a thickness of about 3.18 mm (0.125 inch), preferably about 1.52 mm (0.06 inch), and most preferably at a thickness of about 0.76 mm (0.03 inch). Enhanced processability can be determined, for example, as a reduction in extruder torque during compounding, reduced pressure in injection molding, reduced viscosity, and/or increased cycle time.

Flame retardancy is preferably measured according to the Underwriters' Laboratory UL-94 protocol. A flame retarding amount is an amount effective to render the composition at least a V-2 rating, preferably at least a V-1 rating, and most preferably a V-0 rating after testing in the UL-94 protocol when measured on a test specimen of about 0.76 to 3.18 mm (0.03 to about 0.125 inch) in thickness by about 12.7 mm (0.5 inch) by, about 127 mm (5 inch), preferably about 3.18 mm (0.125 inch) in thickness by about 12.7 mm (0.5 inch) by about 127 mm (5 inch), more preferably about 1.52 mm (0.06 inch) in thickness by about 12.7 mm (0.5 inch) by about 127 mm (5 inch), and most preferably about 0.76 mm (0.03 inch) in thickness by about 12.7 mm (0.5 inch) by about 127 mm (5 inch) dimensions. Enhanced processability can be determined, for example, as a reduction in extruder torque during compounding, reduced pressure in injection molding, reduced viscosity, and/or decreased cycle time.

The amount of at least one phosphoramide or mixture of at least one phosphoramide and at least one phosphorus additive is typically in the range of about 0.1-3 parts, preferably about 0.25-2.5 parts, of phosphorus per 100 parts of resinous materials (phr), all percentages herein being by weight. The total amount of phosphoramide or of phosphoramide/phosphorus additive mixture is most often in the range of about 1-50 phr, preferably 5-35 phr.

Compositions of the present invention can also include effective amounts of at least one additive selected from the group consisting of anti oxidants, silicone fluids and oils, drip retardants, dyes, pigments, colorants, stabilizers, glass fibers, carbon fibers and carbon fibrils, small particle mineral such as day, mica, and talc, antistatic agents, plasticizers, lubricants, and mixtures thereof. These additives are known in the art, as are their effective levels and methods of incorporation. Effective amounts of the additives vary widely, but they are usually present in an amount up to about 50% or more by weight, based on the weight of the entire composition. Especially preferred additives include hindered phenols, thio compounds and amides derived from various fatty acids. The preferred amounts of these additives generally ranges up to about 2% total combined weight based on the total weight of the composition.

In a preferred embodiment, at least one polysiloxane is also present in the compositions of the invention. Polysiloxanes compounds are known per se. Their properties vary from a comparatively low viscous liquid to rubberlike polymers. Polysiloxanes usually consist of a main chain of alternating silicon atoms and oxygen atoms, substituted with various groups at the silicon atom. The polysiloxane compounds may have different structures: homopolymer, block copolymer or random copolymer. Suitable polysiloxanes include liquids in which the substituents at the silicon atoms mainly consist of alkyl groups, for example, methyl groups or phenyl groups, or aryl groups, for example, phenyl groups, or a combination of the two. It is also possible that a part of the silicon atoms is bonded to a hydrogen atom.

It is possible to use polysiloxanes which comprise one or more groups (moieties) which are capable of reacting with a carboxyl group and/or an amine group. Examples of such groups include amine groups, epoxy groups and groups derived from carboxylic acids.

It is sometimes to be preferred to use a polysiloxane compound of formulas: 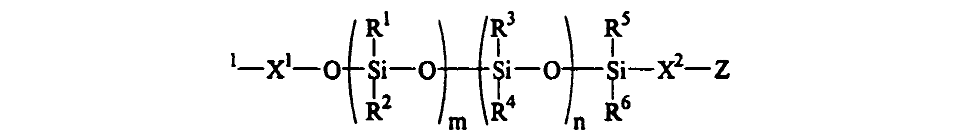 or 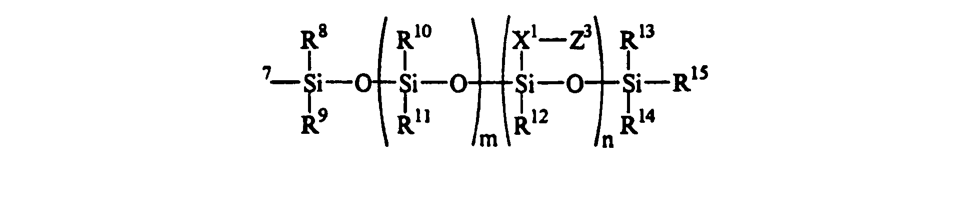 wherein m + n has a value of about 5 to about 2,000, and R¹, R², R³, R⁴, R⁵, R⁸, R⁷, R⁸, R⁹, R¹⁰, R¹¹, R¹², R¹³, R¹⁴, and R¹⁵, each independently of each other, represent a hydrogen atom or one of the following groups having 1 to 12 carbon atoms: alkyl, alkoxy, alkenyl, aryl, aralkyl, alkylaryl, which groups may be halogenated; wherein X¹, X², X³, each independently of each other, represent one of the following groups: alkylene, cycloalkylene, arylene, aralkylene, alkylarylene; wherein Z', Z², Z³ each represent one of the following groups: -NR¹⁶R¹⁷, -NH-(CH₂)ₖ -NR¹⁶R¹⁷ in which R¹⁶ and R¹⁷, each independently of each other, represent a hydrogen atom or an alkyl group having 1-12 carbon atoms, k has a value from 1-10, an aliphatic or cycloaliphatic epoxide, a carboxylic acid group, Z¹ or Z² is a hydrogen atom, in which, however, the polysiloxane compound may not comprise simultaneously an amine group and an epoxide group, or not simultaneously an amine group and a carboxylic acid group, or not simultaneously an epoxide group and a carboxylic acid group. Suitable carboxylic acid groups include acid anhydride groups.

The preparation of the compositions of the present invention is normally achieved by merely blending the ingredients under conditions for the formation of an intimate blend. Such conditions often include mixing in single or twin screw type extruders or similar mixing devices which can apply a shear to the components.

All of the ingredients may be added initially to the processing system, or else certain additives may be precompounded with one or more of the primary components, preferably the PPE, the optional elastomers, and/or the polyamide. It appears that certain properties, such as impact strength and elongation, are sometimes enhanced by initially precompounding the PPE, elastomeric copolymers, optionally with any other ingredients, prior to compounding with the polyamide resin, however, these improvements are done at the expense of increasing the viscosity of the compatibilized composition. While separate extruders may be used in the processing, these compositions are preferably prepared by using a single extruder having multiple feed ports along its length to accommodate the addition of the various components. It is often advantageous to apply a vacuum to the melt through at least one or more vent ports in the extruder to remove volatile impurities in the composition. Those of ordinary skill in the art will be able to adjust blending times and temperatures, as well as component addition, without undue additional experimentation.

It should be clear that methods to make the compositions and articles made from the compositions as disclosed are within the scope of the invention.

The invention will be further illustrated by the following examples.

### EXPERIMENTAL

In the examples the following materials have been used:
- PPE:: a poly(2,6-dimethyl-1,4-phenylene ether) with an intrinsic viscosity of 45 ml/g as measured in toluene at 25°C. and a concentration of 0.6 gram per 100 ml;
- PA-6,6:: a polyamide-6,6 with a viscosity of 54-62 ml/g according to ASTM D789 in a solution of 8.4% by weight of nylon in 90% Formic Acid and an amine endgroup number of µeq./g.;
- CAH:: citric acid monohydrate;
- XPP:: N,N'-bis-[di-(2,6-xylenoxy)phosphinyl]piperazine, a compound according to formula 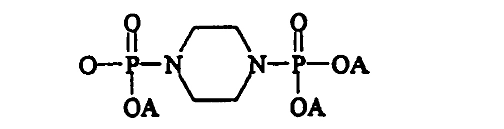 wherein each A is 2,6-dimethylphenyl residue
- RDP: resorcinol bis(diphenyl) phosphate
- BPA-DP: bisphenol A bis(diphenyl) phosphate
- Si oil: an amine functionalized polysiloxane fluid commercially available from GE Silicones as grade SF1706
- BP: boron phosphate commercially available from Budenheim as Budit 321

The ingredients were compounded in the weight ratios as indicated in the following table in a twin-screw extruder with temperature settings over the length of the extruder between about 280° and about 310°C. The screw speed was 300 rpm, the throughput 10 kilograms per hour. All ingredients were fed at the throat of the extruder with the exception of the polyamide; the polyamide was fed downstream about halfway the length of the extruder. The strands coming from the extruder were pelletized in a laboratory equipment and dried for about 3 hours at about 110°C. The dried pellets were injection molded into standard ASTM test specimens for measurement of physical properties. The FOT (total flameout times for first and second ignitions for 5 bars) and UI-94 classification was determined for each sample and the results are given in Table I.

**Table I.**

| Sample: | 1 | 2 | 3 | 4 | 5 | 6 | 7 | 8 |
|---|---|---|---|---|---|---|---|---|
| PPE | 31.6 | 28.3 | 26.6 | 29.9 | 33.3 | - | 30.8 | 33.3 |
| CAH | 0.78 | 0.78 | 0.78 | 0.78 | 0.78 | - | 0.78 | 0.78 |
| XPP | 5 | 15 | 15 | 10 | 5 | 10 | 10 | 0 |
| Si oil | 3.4 | 0 | 3.4 | 1.7 | 0 | 0 | 0 | 2.2 |
| BP | 0 | 0 | 0 | 0 | 0 | 0 | 0 | 2.8 |
| PA-6,6 | 56.3 5 | 53.0 5 | 51.3 5 | 54.7 | 58.0 4 | 90 | 55.55² | 58.0 5 |
| adds¹ | 0.67 | 0.67 | 0.67 | 0.67 | 0.67 | 0 | 0.67 | 0.67 |

| Properties | | | | | | | | |
|---|---|---|---|---|---|---|---|---|
| UL-94 | V1 | V0 | V0 | V0 | fail | -- | V0 | V0 |
| FOT 1 | 8.0 | 2.0 | 1.0 | 2.0 | 49.2 | -- | 2.6 | 3.3 |
| FOT 2 | 16.2 | 4.8 | 4.0 | 5.6 | 0.0 | -- | 4.2 | 5.5 |

| | | | | | | | | |
|---|---|---|---|---|---|---|---|---|
| ¹ denotes a combination of 0.33 hindered phenol, 0.22 of 50% by weight KI in water, 0.11 carbon black, 0.01 Cul wherein all weights are by weight; | | | | | | | | |
| ² denotes the composition of sample 6. | | | | | | | | |

As can be seen from the properties of the compositions presented in Table I, compositions containing a phosphoramide (e.g., XPP) can achieve very short flame out times and very desirable V1 and V0 classification in the Underwriter's Laboratory testing protocol. Moreover, the addition of silicone oil used in combination with the phosphoramide allows for similar results at lower levels of phosphoramide.

The above results containing the phosphoramide are unexpected as phosphate esters commonly used as flame retardants typically react with the polyamide and interfere with the compatibilization chemistry for PPEpolyamide compositions. The data in Table II below illustrates this point by comparing the amine endgroup analysis and molecular weights of polyamide 6,6 heated with the XPP, RDP, and BPA-DP.

**Table II.**

| | Amine endgroup (µeq/g) | molecular weight (versus polystyrene) |
|---|---|---|
| Heated PA 6,6 (control) | 43.9 | 70,600 |
| PA 6,6/RDP | 28.6 | 66,200 |
| PA 6,6/BDA-DP | 37.1 | 73,800 |
| PA 6,6/XPP | 44.0 | 70,500 |

The above data demonstrates that both RDP and BPA-DP, illustrative phosphate esters of the prior art, affect both the amine endgroup number and the molecular weight of the polyamide resin. XPP, a phosphoramide, unexpectedly did not significantly affect the amine endgroup number or the molecular weight of the polyamide. The amine endgroup number and molecular weight of the polyamide are believed to be key factors in the compatibilization of the PPE and polyamide and the ultimate physical properties of the compositions.

It should be clear that the present invention encompasses novel compositions and articles as specified in the claims.

## Claims

1. A resin composition comprising:
a) a compatibilized polyphenylene ether-polyamide resin composition and
b) at least one phosphoramide of the formula: 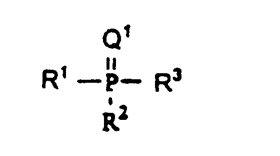 wherein R¹ is an amine residue, and R² and R³ are independently an alkyloxy residue, aryloxy residue, aryloxy residue containing at least one alkyl substitution, or an amine residue, and Q¹ is an oxygen or sulfur atom.

2. The composition of claim 1 wherein R¹ is of the formula: 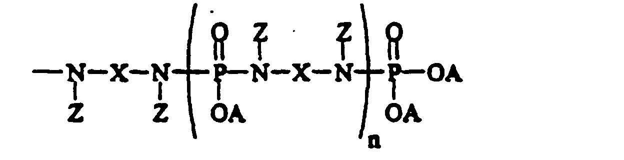 wherein each A is independently an aromatic or an aromatic radical containing at least one alkyl substitution, each Z is independently an alkyl radical or an aryl radical, each X is independently an alkyl radical or an aryl radical, and n is from 0 to about 5, and Q is an oxygen atom.

3. The composition of claim 1 wherein R¹ is of the formula: 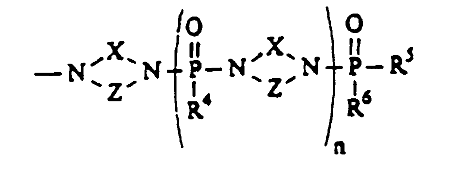 wherein each X is independently alkyl, aryl, or alkaryl, each Z is independently alkyl, each of R⁴, R⁵, and R⁶ is independently an aryloxy residue, an aryloxy residue containing at least one alkyl substitution, or an amine residue, and n is from 0 to about 5, and Q is an oxygen atom.

4. The composition of claim 1 wherein the phosphoramide comprises a phosphoramide of the formula: 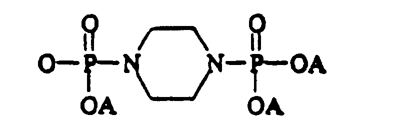 wherein each A moiety is independently a 2,6-dimethylphenyl moiety or a 2,4,6-trimethylphenyl moiety, and Q is n oxygen atom.

5. The composition of claim 1 wherein the phosphoramide comprises a phosphoramide of the formula: 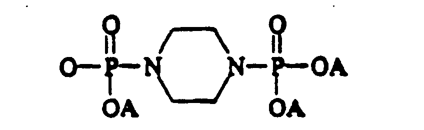 wherein each A moiety is a 2,6-dimethylphenyl moiety.

6. The composition of claim 1 wherein the phosphoramide is present in an amount effective to render the resin compsoition a flame rating of V-0, V-1, or V-2 in the Underwriter's Laboratory UL-94 protocol when measured on a test specimen of about 6.35 mm (0.25 inch) by about 12.7 mm (0.5 inch) by about 127 mm (5 inch) dimensions.

7. The composition of claim 1 wherein the phosphoramide has a glass transition point of at least about 0°C.

8. The composition of claim 1 wherein the total amount of phosphorus per 100 parts of resinous materials is in the range of about 0.1-3 parts by weight of phosphorus.

9. The composition of claim 1 further comprising a polysiloxane.

10. An article made from the composition of claim 1.

## Patentansprüche

1. Eine Harzzusammensetzung umfassend:
(a) eine verträglich gemachte Polyphenylenether-Polyamid Harzzusammensetzung
und
(b) wenigstens ein Phosphoramid der Formel 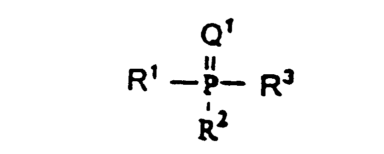
worin R¹ ein Aminrest ist, und R² und R³ unabhängig ein Alkyloxyrest, Aryloxyrest, Aryloxyrest enthaltend wenigstens eine Alkylsubstitution, oder ein Aminrest sind und Q¹ ein Sauerstoff- oder Schwefelatom ist.

2. Zusammensetzung nach Anspruch 1, **dadurch gekennzeichnet, dass** R¹ die Formel besitzt: 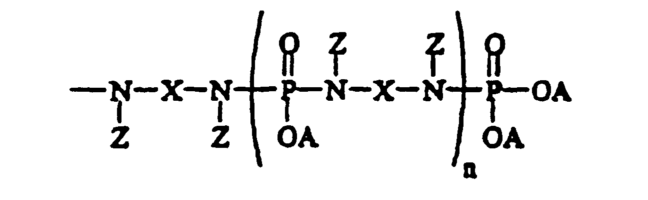 worin jedes A unabhängig ein aromatischer oder ein aromatischer Rest enthaltend wenigstens eine Alkylsubstitution ist, jedes Z unabhängig ein Alkylrest oder ein Arylrest ist, jedes X unabhängig ein Alkylrest oder ein Arylrest ist, und n zwischen 0 und etwa 5 ist, und Q ein Sauerstoffatom ist.

3. Zusammensetzung nach Anspruch 1, **dadurch gekennzeichnet, dass** R¹ die Formel besitzt: 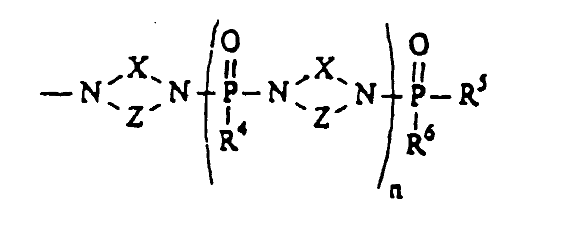 worin jedes X worin unabhängig Alkyl, Aryl, oder Alkaryl ist, jedes Z unabhängig Alkyl ist, R⁴, R⁵ und R⁶ jeweils unabhängig ein Aryloxyrest, ein Aryloxyrest enthaltend wenigstens eine Alkylsubstitution, oder ein Aminrest ist, und n zwischen 0 und etwa 5 ist, und Q ein Sauerstoffatom ist.

4. Zusammensetzung nach Anspruch 1, **dadurch gekennzeichnet, dass** das Phosphoramid ein Phosphoramid der Formel aufweist: 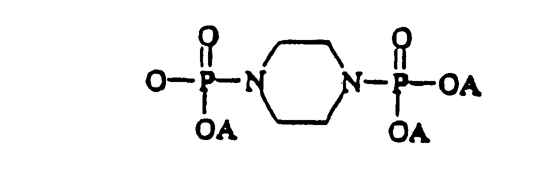 worin jeder A-Rest unabhängig ein 2,6-Dimethylphenylrest oder ein 2,4,6-Trimethylphenylrest ist und Q n Sauerstoffatom ist.

5. Zusammensetzung nach Anspruch 1, **dadurch gekennzeichnet, dass** das Phosphoramid ein Phosphoramid der Formel umfasst: 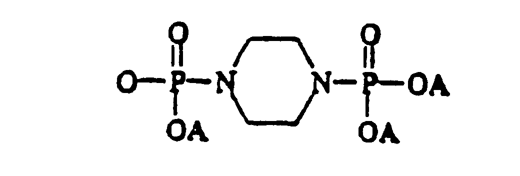 worin jeder A-Rest ein 2,6-Dimethylphenylrest ist.

6. Zusammensetzung nach Anspruch 1, **dadurch gekennzeichnet, dass** das Phosphoramid in einer Menge vorhanden ist, die ausreicht, der Zusammensetzung eine Flammhemmenbeurteilung von V-0, V-1 oder V-2 gemäß dem Underwriter's Laboratory UL-94 Protokoll zu verleihen, gemessen an einem Testkörper der Dimension von etwa 6,35 mm (0,25 Inch) x etwa 12,7 mm (0,5 Inch) x etwa 127 mm (5 Inch).

7. Zusammensetzung nach Anspruch 1, **dadurch gekennzeichnet, dass** das Phosphoramid eine Glasübergangstemperatur von wenigstens etwa 0 °C hat.

8. Zusammensetzung nach Anspruch 1, **dadurch gekennzeichnet, dass** die Gesamtmenge an Phosphor pro 100 Teile des Harzmaterials im Bereich von etwa 0,1-3 Gewichtsteile des Phosphors liegt.

9. Zusammensetzung nach Anspruch 1, weiterhin aufweisend ein Polysiloxan.

10. Ein Gegenstand hergestellt aus der Zusammensetzung nach Anspruch 1.

## Revendications

1. Composition à base de résine, qui comprend :
a) un mélange de résine de poly(oxyde de phénylène) et de résine de polyamide, rendues compatibles, et
b) au moins un phosphoramide de formule : 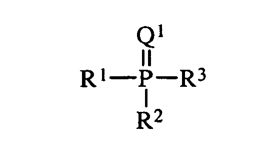
dans laquelle R¹ représente un reste d'amine, R² et R³ représentent chacun indépendamment un groupe alcoxy, un groupe aryloxy, un groupe aryloxy portant au moins un substituant alkyle, ou un reste d'amine, et Q¹ représente un atome d'oxygène ou de soufre.

2. Composition selon la revendication 1, pour laquelle R¹ est un groupe de formule : 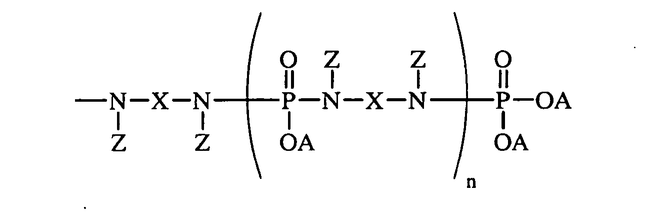 dans laquelle chaque A représente indépendamment un radical aromatique ou un radical aromatique portant au moins un substituant alkyle, chaque Z représente indépendamment un groupe alkyle ou un groupe aryle, chaque X représente indépendamment un groupe alkylène ou un groupe arylène, et n est un nombre de 0 à environ 5,
et Q¹ représente un atome d'oxygène.

3. Composition selon la revendication 1, pour laquelle R¹ est un groupe de formule : 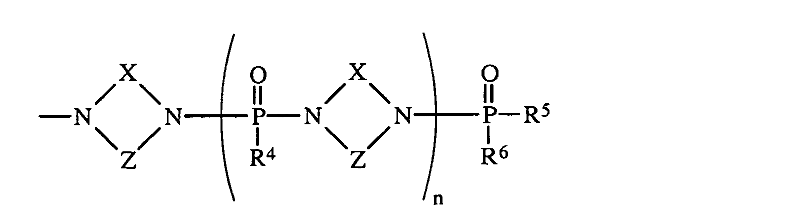 dans laquelle chaque X représente indépendamment un groupe alkylène, arylène ou alkylarylène, chaque Z représente indépendamment un groupe alkylène, chacun de R⁴, R⁵ et R⁶ représente indépendamment un groupe aryloxy, un groupe aryloxy portant au moins un substituant alkyle, ou un reste d'amine, et n est un nombre de 0 à environ 5,
et Q¹ représente un atome d'oxygène.

4. Composition selon la revendication 1, dont le phosphoramide comprend un phosphoramide de formule : 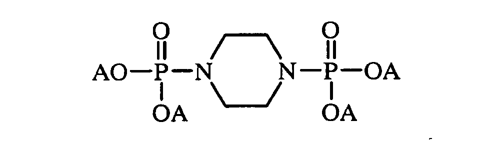 dans laquelle chaque A représente indépendamment un groupe 2,6-diméthylphényle ou un groupe 2,4,6-triméthylphényle.

5. Composition selon la revendication 1, dont le phosphoramide comprend un phosphoramide de formule : 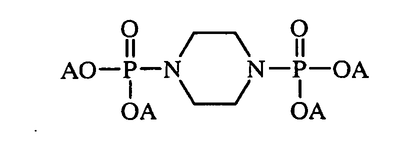 dans laquelle chaque A représente un groupe 2,6-diméthylphényle.

6. Composition selon la revendication 1, dans laquelle le phosphoramide est présent en une proportion permettant d'attribuer à la composition à base de résine une note d'inflammabilité V-0, V-1 ou V-2 dans le test suivant le protocole UL-94 de Underwriter's Laboratory, lorsque les mesures sont effectuées sur un échantillon de dimensions environ 6,35 mm (0,25 pouce) par environ 12,7 mm (0,5 pouce) par environ 127 mm (5 pouces).

7. Composition selon la revendication 1, dont le phosphoramide a une température de transition vitreuse d'au moins environ 0 °C.

8. Composition selon la revendication 1, dont la quantité totale de phosphore pour 100 parties de matières résineuses est comprise dans l'intervalle allant d'environ 0,1 partie à environ 3 parties en poids de phosphore.

9. Composition selon la revendication 1, qui renferme en outre un polysiloxane.

10. Article fabriqué à partir de la composition selon la revendication 1.
